# EUROPEAN PATENT APPLICATION

(11) **EP 3 723 185 A1**
(43) Date of publication of application: **14.10.2020**
(21) Application number: 19168327.5
(22) Date of filing: 10.04.2019
(51) Int. Cl.: H01M 10/42, H01M 10/48, G01R 31/367, G01R 31/392

(54) **METHOD FOR ENHANCING A BATTERY MODULE MODEL OF A BATTERY MODULE TYPE**

(71) Applicant: Siemens Aktiengesellschaft, 80333 München (DE)
(72) Inventor: Fenech, Kristian, 1015 Budapest (HU); Balazs, Gergely György, 1034 Budapest (HU)
(74) Representative: Maier, Daniel Oliver

(57) **Abstract**

Method for enhancing a battery module model of a battery module type, comprising the steps of:
a) exposing a battery module (1) of the battery module type including a multiplicity of battery cells (2) to a first environment (10) and measuring an initial battery parameter (11-13),
b) training of the battery module model of the battery module type with the initial battery parameter (11-13) based on machine learning techniques,
c) operating the battery module (1) at a second environment (20) and capturing an operating battery parameter (21, 22),
d) training the battery module model with the operating battery parameter (21, 22),
e) calculating an EOL parameter (40) relating to an end-of-life prediction of the battery module (1), wherein, if the EOL parameter (40) exceeds a predetermined threshold value, continue with step f), else continue with step c),
f) exposing the battery module (1) to a third environment (30) and measuring a final battery parameter (31, 32),
g) training of the battery module model with the final battery parameter (31, 32).

## Description

The invention relates to a method for enhancing a battery module model of a battery module type.

The invention relates further to a device and a system carrying out the method according to the invention.

The aging of a Lithium-Ion battery pack is a very important issue, which two factors contribute essentially. The first, calendar aging is due to the progression of time since the manufacturing of the cell or group of cells within a battery pack. The second is aging due to charge-discharge cycles. However, this second aging factor is a highly non-linear process in which many factors such as temperature, charge/ discharge rate, and changes in charge/ discharge rate play a role.

This lack of Information regarding the battery aging can result in incorrect capacity estimations for state of charge algorithms.

In prior art battery aging and capacity was estimated by specific offline measurements to assess the remaining battery capacity. Such measurements include Open Circuit Voltage (OCV) measurement to deduce Internal resistance. Additionally, low C-rate charge-discharge measurements can be made to establish remaining capacity.

The objective of the invention is to provide an enhanced battery module model of a battery module type in order to allow accurately to estimate the effective age of a battery module of the battery module type without interrupting the continuous usage of the module under investigation.

The objective of the invention is solved by the method according to the preamble of claim 1, comprising the steps of:
a) exposing a battery module of the battery module type including a multiplicity of battery cells to a first environment and measuring at the first environment at least one initial battery parameter based on at least one time parameter,
b) setup and training of the battery module model of the battery module type with the at least one initial battery parameter based on the at least one time parameter and based on machine learning techniques,
c) operating the battery module at a second environment and capturing at least one operating battery parameter,
d) training the battery module model with the at least one operating battery parameter based on the at least one time parameter,
e) calculating an EOL parameter relating to an end-of-life prediction of the battery module.
f) exposing the battery module to a third environment and measuring at the third environment at least one final battery parameter based on the at least one time parameter,
g) training of the battery module model with the at least one final battery parameter based on the at least one time parameter.

Thus, the estimation on active/in field batteries can be performed without interfering with day-to-day operations.

This is achieved by the remote transmission of in use battery characteristics to a remote server for processing eliminating the constraint set by low power processors typically found within local battery management systems.

Further, the method enhances safety by detecting battery packs which may be undergoing enhanced degradation due to manufacturing, environmental or abnormal usage patterns.

This is achieved by the aging prediction model which can detect such packs as described.

Moreover, the down-time and costs are minimized due to unrecognized battery packs which have decreased beyond useable life.

This is achieved as the battery Information is automatically made available and comparison to a reference pack made an optimized maintenance schedule can be derived.

Additionally, by predicting aging and capacity on a pre-trained model means the battery pack under observation does not need to be removed for lab tests.

In one further development of the invention it is foreseen, that the at least one initial battery parameter and/or the at least one operating battery parameter and/or the at least one final battery parameter is related to a voltage, a current and/or a charge of the battery module or at least one cell of the multiplicity of battery cells.

In another further development of the invention it is foreseen, that the measuring step f) is performed by applying at least one controlled discharge on the battery module and/ or at least one cell of the multiplicity of battery cells.

In another further development of the invention it is foreseen, that after the measuring step f) the at least one final battery parameter is compared with the at least one initial battery parameter based on Bayesian classification, which classification results are used at the training step h).

The objective of the invention is solved by a device for predicting the effective age of a battery module including a multiplicity of battery cells, wherein the device is configured to
- receive at least one battery parameter,
- setup a battery module model based on machine learning techniques using the at least one battery parameter,
- train the battery module model with the at least one battery parameter set,
- output an end-of-life prediction parameter of the battery module based on the battery module model,
- carry out the step after the measuring step f) according the method of the invention.

The objective of the invention is solved by a system for predicting the effective age of a battery module, wherein the system comprises a battery module including a multiplicity of battery cells and a prediction device according to the device according to the invention.

It is clear, that further not shown parts are necessary for the operation of a battery module e.g. electronic control components or measurement equipment. For the sake of better understanding these parts are not illustrated and described.

The invention is described by an embodiment in the accomplished figures in detail. The drawings show in
- Fig. 1: a schematic illustration of a battery module of the battery module type including a multiplicity of battery cells,
- Fig. 2: a schematic illustration of an embodiment of the steps of the method according to the invention,
- Fig. 3: a further schematic illustration of the method according to Fig. 1,
- Fig. 4: a schematic illustration of an embodiment of a device according to the invention.

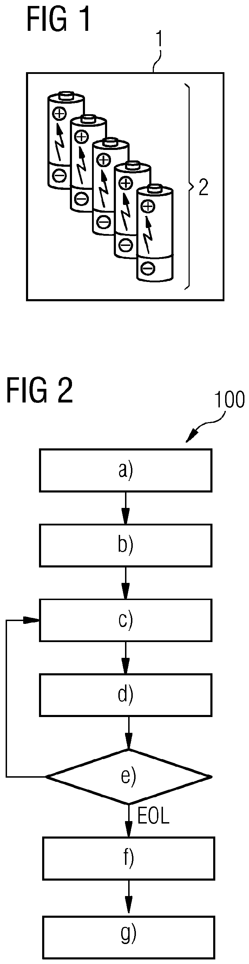

**Fig. 1** shows a schematic illustration of a battery module 1 of the battery module type including a multiplicity of battery cells 2.

**Fig. 2** shows the method for enhancing a battery module model of a battery module type, comprising the steps of:
a) exposing a battery module 1 of the battery module type including a multiplicity of battery cells 2 to a first environment 10 and measuring at the first environment 10 at least one initial battery parameter 11-13 based on at least one time parameter 3,
b) setup and training of the battery module model of the battery module type with the at least one initial battery parameter 11-13 based on the at least one time parameter 3 and based on machine learning techniques,
c) operating the battery module 1 at a second environment 20 and capturing at least one operating battery parameter 21, 22,
d) training the battery module model with the at least one operating battery parameter 21, 22 based on the at least one time parameter 3,
e) calculating an EOL parameter 40 relating to an end-of-life prediction of the battery module 1, wherein, if the EOL parameter 40 exceeds a predetermined threshold value, continue with step f), else continue with step c),
f) exposing the battery module 1 to a third environment 30 and measuring at the third environment 30 at least one final battery parameter 31, 32 based on the at least one time parameter 3,
g) training of the battery module model with the at least one final battery parameter 31, 32 based on the at least one time parameter 3.

Within step a) a set of battery modules can be used for providing initial data for the setup of the battery module model in step b).

The at least one initial battery parameter 11-13 and the at least one operating battery parameter 21, 22 and the at least one final battery parameter 31, 32 are related to a voltage, a current and a charge of the battery module 1 and at least one cell of the multiplicity of battery cells 2.

The measuring step f) is performed by applying at least one controlled discharge on the battery module 1, i.e. at least one cell of the multiplicity of battery cells 2.

After the measuring step f) the at least one final battery parameter 31, 32 is compared with the at least one initial battery parameter 11-13 based on Bayesian classification, which classification results are used at the training step h).

The first environment 10 and the third environment 30 can be the same, e.g. at a lab.

As a result, an aged battery module at end-of-life can provide important data for the battery module model for another battery module of the same battery type during its ongoing operation.

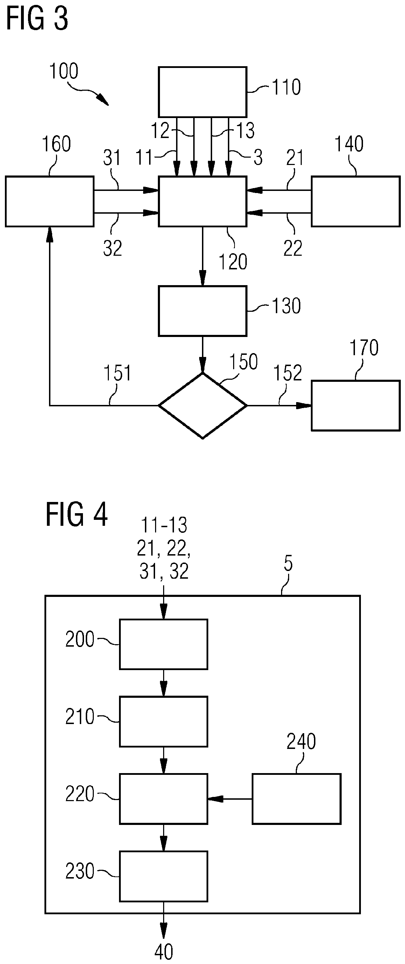

**Fig. 3** shows an alternative schematic illustration 100 of the embodiment of the steps of the method according to the invention.

Within step a) controlled charge/ discharge measurements 110 are performed, delivering the initial parameters for current 11, the initial parameters for voltage 12 and the initial parameters for charge 13 at the initial environment 10 based on the time parameter 3.

The time parameter 3 can be a reference to all other measurements, i.e. measurements can be normalized to the time parameter 3.

Within step b) the battery module model is setup and trained, i.e. an aging prediction model training 120 is performed, with the initial battery parameters 11-13 based on the time parameter 3 and based on machine learning techniques.

Within step c) charge/ discharge measurements 140 are performed during the operation of the battery module, e.g. at a car, an aircraft or a mobile computer, delivering as in-field battery reporting 140 the operating parameter for current 21 and the operating parameter for voltage 22 at the operating environment 20.

Subsequently, an aging model prediction 130 is performed, where the end-of-life parameter EOL, 40 is calculated and compared 150 to a pre-set value, e.g. 70%, 75% or 80% of the original, initial capacity of the battery module. The pre-set value depends on the application where the battery module is used and can vary over a wide range.

When end-of-life of the battery module is reached in path 151, further controlled charge/ discharge measurements 160 are performed in step f), delivering the final parameters for current 31 and the final parameters for voltage 32 at the final environment 30 based on the time parameter 3.

As long the end-of-life of the battery module in path 152 is not yet reached, the battery operation will continue in path 170. i.e. the "regular" battery operation within its application is continued, and periodically step c) is repeated.

Fig. 4 depicts an embodiment of a device 5 according to the invention, which can be used in a system as well. The device 5 for enhancing a battery module model of a battery module type is configured to:
- receive 200 at least one battery parameter 11-13, 21, 22, 31, 32 of a battery module 1 which includes a multiplicity of battery cells,
- setup 210 a battery module model based on machine learning techniques using the at least one battery parameter 11-13,
- train 220 the battery module model with the at least one battery parameter set 11-13, 21, 22, 31, 32,
- output 230 an end-of-life prediction parameter 40 of the battery module 1 based on the battery module model,
- carry out 240 after the measuring step f) a comparison of the at least one final battery parameter 31, 32 with the at least one initial battery parameter 11-13 based on Bayesian classification, which classification results are used at the training step h).

Thus, the device 5 provides an improved battery module model of a battery module 1 and/or its EOL parameter 40.

**List of Reference Numerals:**
- 1: battery module
- 2: multiplicity of cells of the battery module
- 3: time parameter
- 4: battery model
- 5: prediction device
- 10: initial environment
- 11: initial parameter for current
- 12: initial parameter for voltage
- 13: initial parameter for charge
- 20: operating environment
- 21: operating parameter for current
- 22: operating parameter for voltage
- 30: final environment
- 31: final parameter for current
- 32: final parameter for voltage
- 40: EOL parameter
- 100: method
- 110: Controlled charge/ discharge measurements
- 120: Aging prediction model training
- 130: Aging model prediction
- 140: In-field battery reporting
- 150: End of life?
- 151: Yes
- 152: No
- 160: Extract battery and perform lab measurement
- 170: actually no action of battery model adaption
- 200: receive measurement data as parameters
- 210: setup a battery module model
- 220: train the battery module model
- 230: output an end-of-life prediction parameter
- 240: carry out the method of the invention

## Claims

1. Method for enhancing a battery module model of a battery module type, comprising the steps of:
a) exposing a battery module (1) of the battery module type including a multiplicity of battery cells (2) to a first environment (10) and measuring at the first environment (10) at least one initial battery parameter (11-13) based on at least one time parameter (3),
b) setup and training of the battery module model of the battery module type with the at least one initial battery parameter (11-13) based on the at least one time parameter (3) and based on machine learning techniques,
c) operating the battery module (1) at a second environment (20) and capturing at least one operating battery parameter (21, 22),
d) training the battery module model with the at least one operating battery parameter (21, 22) based on the at least one time parameter (3),
e) calculating an EOL parameter (40) relating to an end-of-life prediction of the battery module (1), wherein, if the EOL parameter (40) exceeds a predetermined threshold value, continue with step f), else continue with step c),
f) exposing the battery module (1) to a third environment (30) and measuring at the third environment (30) at least one final battery parameter (31, 32) based on the at least one time parameter (3),
g) training of the battery module model with the at least one final battery parameter (31, 32) based on the at least one time parameter (3).

2. Method according to the preceding claim, wherein the at least one initial battery parameter (11-13) and/or the at least one operating battery parameter (21, 22) and/or the at least one final battery parameter (31, 32) is related to a voltage, a current and/or a charge of the battery module (1) or at least one cell of the multiplicity of battery cells (2).

3. Method according to one of the preceding claims, wherein the measuring step f) is performed by applying at least one controlled discharge on the battery module (1) and/ or at least one cell of the multiplicity of battery cells (2).

4. Method according to one of the preceding claims, wherein after the measuring step f) the at least one final battery parameter (31, 32) is compared with the at least one initial battery parameter (11-13) based on Bayesian classification, which classification results are used at the training step h).

5. Device (5) for predicting the effective age of a battery module (1) including a multiplicity of battery cells (2), **characterized in that** the device is configured to
• receive (200) at least one battery parameter (11-13, 21, 22, 31, 32),
• setup (210) a battery module model based on machine learning techniques using the at least one battery parameter (11-13),
• train (220) the battery module model with the at least one battery parameter set (11-13, 21, 22, 31, 32),
• output (230) an end-of-life prediction parameter of the battery module (1) based on the battery module model,
• carry out (240) the step according the method of claim 4.

6. System for predicting the effective age of a battery module, **characterized in that** the system comprises a battery module (1) including a multiplicity of battery cells (2) and a prediction device (5) according to the preceding claim.
